# EUROPEAN PATENT APPLICATION

(11) **EP 1 420 438 A2**
(43) Date of publication of application: **19.05.2004**
(21) Application number: 03026193.7
(22) Date of filing: 17.11.2003
(51) Int. Cl.: H01L 21/3065

(54) **Method and apparatus for etching a deep trench**

(30) Priority: 15.11.2002 US 298040
(71) Applicant: Applied Materials, Inc., Santa Clara, California 95054 (US)
(72) Inventor: Nallan, Padmapani C., San Jose, CA 95148 (US); Hsu, Shu-Ting S., Pleasanton, CA 94588 (US); Kumar, Ajay, Sunnyvale, CA 94087 (US)
(74) Representative: Zimmermann, Gerd Heinrich

(57) **Abstract**

A method for plasma etching a trench in a semiconductor substrate using a plurality of processing cycles comprising plasma etch and deposition periods, wherein a substrate bias power is pulsed during the etch periods.

## Description

The present invention generally relates to semiconductor substrate processing systems. More specifically, the present invention relates to a method and apparatus for performing an etch process in a semiconductor substrate processing system.

Micro Electro-Mechanic Systems, or MEMS, are very small electro-mechanical devices such as actuators, sensors, and the like. Unlike conventional mechanical devices, MEMS are generally fabricated on a semiconductor substrate such as a silicon (Si) wafer and may be monolithically integrated with electronic circuits that are formed on the same substrate.

Manufacturing of MEMS comprises processes that have limited analogies to the fabrication of electronic integrated circuits on semiconductor substrates. One such process is a process of etching a trench having a width of about 1 to 20 µm and an aspect ratio of about 5 to 50 or more. Herein such trenches are referred as deep trenches and the term aspect ratio refers to a height of the trench divided by its width.

A deep trench is generally formed using an etch process, e.g., a Time Multiplex Gas Modulation (TMGM) process, which comprises a plurality of alternating cycles of etching and deposition that are serially performed in a single etch reactor, i.e., in situ. More specifically, the TMGM etch process is a plasma process that forms a high aspect ratio trench at a high etch rate. The TMGM process etches a material for a period of time then deposits a protective film upon the previously etched surface to protect the surface, typically the sidewalls of the trench, from further etching. These two steps are repeated as a deeper and deeper trench is formed.

As a result of the TMGM etch process, the sidewall of the trench acquires a periodic pattern of variations in the width with the depth of the trench, i.e., a scalloping pattern forms along the depth of the trench. The scalloping pattern is originated by an alternating nature of cycles of etching and deposition and may comprise "peaks" and "valleys" having a lateral height of about 0.2-0.4 µm. Such patterning of the sidewall is a drawback of the TMGM etch process. The scalloping pattern increases roughness of a sidewall surface of the trench and may render an electro-mechanical device such as MEMS to operate sub-optimally or not at all.

Therefore, there is a need in the art for a method and apparatus for etching a deep trench in a semiconductor substrate during fabrication of MEMS or other semiconductor devices such that the trench has reduced scalloping.

This problem is solved by the method according to claim 1 and the computer-readable medium according to claim 14, the latter being a computer-related invention.

Preferred embodiments, aspects and improvements of the invention are disclosed in the description, the figures and the depending claims.

The invention is a computer-related invention, which is also directed to an apparatus for carrying out the disclosed method. These steps may be performed by way of hardware components, a computer programmed by appropriate software, by any combination of the two or in any other manner. Furthermore, the invention is also directed to methods by which the described apparatus operates.

A method for plasma etching a trench in a semiconductor substrate using a plurality of processing cycles comprising plasma etch and deposition periods, wherein a substrate bias power is pulsed during the etch periods. In one embodiment for etching a deep trench in a silicon substrate, the deposition period is performed using a fluorocarbon or hydrofluorocarbon that forms a protective polymeric coating on the sidewalls of the trench, and the etch period is performed using sulfur hexafluoride. As a result of the pulsed bias power, the resulting trench has side walls that are substantially less scalloped than the scalloping of the prior art.

The teachings of the present invention can be readily understood by considering the following detailed description in conjunction with the accompanying drawings, in which:

FIGS. 1A-1F together depict a sequence of schematic, cross-sectional views of a substrate illustratively having a deep trench being formed in accordance with the present invention;

FIG. 2 is a timing diagram of an etch process in accordance with one embodiment of the present invention;

FIG. 3 is a timing diagram of a substrate bias power during an etch step of a process of FIG. 1 in accordance with one embodiment of the present invention;

FIG. 4 depicts a flow diagram of a method for plasma etching a deep trench in accordance with the present invention;

FIG. 5 depicts a schematic diagram of a plasma processing apparatus of the kind used in performing the etch process according to one embodiment of the present invention; and

FIGs. 6A and 6B are representations of images from a scanning electron microscope that respectively show the etching results of the prior art process and the inventive process.

To facilitate understanding, identical reference numerals have been used, where possible, to designate identical elements that are common to the figures.

It is to be noted, however, that the appended drawings illustrate only typical embodiments of this invention, and are therefore not to be considered limiting of its scope, for the invention may admit to other equally effective embodiments.

The present invention is a method and apparatus for etching a deep trench that comprises a plurality of cycles of plasma processing that are performed in situ within an etch reactor. Each such cycle comprises an etch step and a deposition step. The etch and deposition steps are individual plasma processes that are defined by a composition of a gaseous mixture that is supplied into a reaction chamber of the etch reactor. The etch reactor generally is a reactor comprising a source of power for generating and maintaining a plasma (referred to herein as source power) and a source of power for biasing a substrate (referred to herein as bias power). The invention uses pulsed bias power during the etch step to reduce scalloping of the trench sidewalls. The terms wafer and substrate are used interchangeably herein.

In the inventive method, during the etch step, the bias power is deliberately pulsed while the source power is continuously applied. In one embodiment, the method etches trenches that have a width of about 1 to 20 µm and an aspect ratio of about 5 to 50. Such trenches are referred herein as deep trenches. Further examination of the process has revealed that the pulsing of the bias power reduces in-process charging of a surface of the trench, substantially reduces scalloping, increases the etch rate, and reduces notching of the sidewalls at a bottom of the trench.

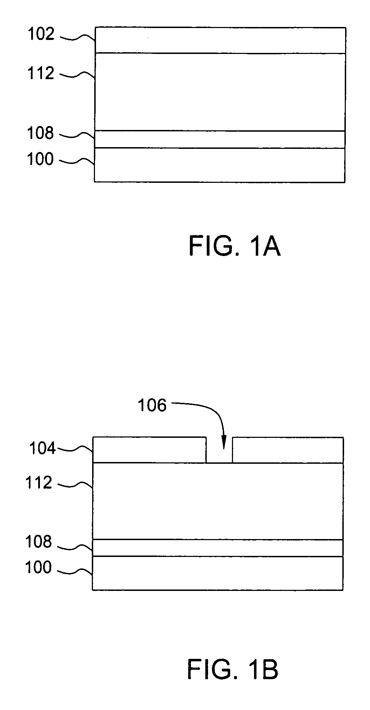

FIGS. 1A-1F depict a sequence of schematic, cross-sectional views of a substrate that has an illustrative deep trench being formed in accordance with the present invention. The cross-sectional views in FIGS. 1A-1 F relate to the individual processes that are used to form the trench. For purposes of clarity, sub-processes and lithographic routines (i.e., exposure and development of photoresist and the like) known in the art are not shown in FIGS. 1A-1F. The images in FIGS. 1A-1F are not depicted to scale and are simplified for illustrative purposes.

FIG. 1A depicts one illustrative example of a wafer 100 (e.g., a silicon wafer) having an etch stop layer 108, a layer 112 of material to etched, and an etch mask layer 102. The etch stop layer 108 may be formed from silicon dioxide (SiO₂), silicon carbide (SiC), and the like. A material of the etch stop layer 108 is selected to best define an end point during a deep trench etch process (discussed in reference to FIG. 1C below). The layer 112 is generally a silicon layer that is deposited on the wafer 100 using a vacuum deposition method such as physical vapor deposition (PVD), chemical vapor deposition, and the like to a thickness of between 1 and 100 µm. However, the layer 112 may be formed from a material other than Si.

The etch mask layer 102 generally is a photoresist layer that is formed using a conventional photoresist application routine to a thickness of about 1 µm. Further, the mask layer 102 may comprise an anti-reflective layer (not shown) that controls a reflection of the light during exposure of the photoresist. The anti-reflective layer generally is formed on the silicon layer 112 prior to application of the photoresist layer 102 or, alternatively, is deposited on top of the layer 102. As feature sizes are reduced, inaccuracies in an etch mask pattern transfer process can arise from optical limitations inherent to the lithographic process such as the light reflection. Such anti-reflective layer may be composed from silicon nitride (SiN), polyamides, and the like. In some applications, the anti-reflective layer may not be necessary. As such, the anti-reflective layer is considered optional.

FIG. 1B depicts the wafer 100 after the photoresist layer 102 has been processed using a lithographic patterning routine, i.e., the photoresist is exposed through a patterned mask, developed, and then the undeveloped portion of the photoresist is removed. The remaining developed photoresist is generally a carbon-based polymer that forms an etch mask 104 on top of the wafer 100. The etch mask 104 exposes a region 106 to further processing. As such, the etch mask 104 defines location and topographic dimensions of a trench to be formed in the layer 112.

In an alternative embodiment (not shown), the layer 102 may be formed from an inorganic material such silicon dioxide (SiO₂) to form a hard (inorganic) etch mask. In this embodiment, photoresist is applied over a layer of the inorganic material and the photoresist etch mask 104 is formed upon, as described above. Further, the inorganic material is removed in the region 106 using a dry or wet etch process followed by a photoresist stripping process. The stripping process leaves the hard etch mask resting upon the layer 112. Similar to the photoresist etch mask 104, the hard etch mask exposes the region 106 during etching the trench.

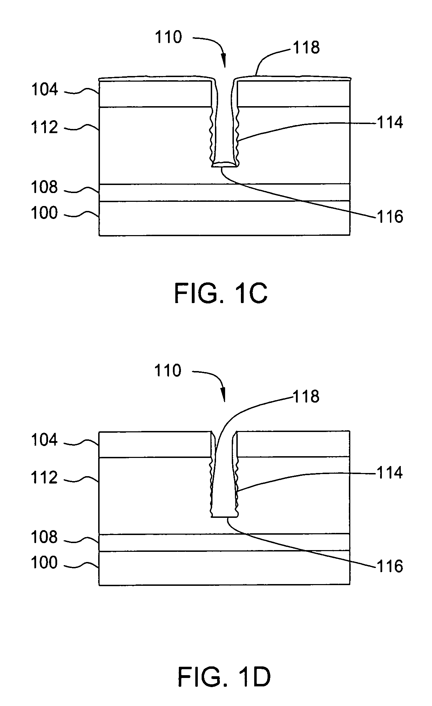

FIGS. 1C and 1D depict a trench 110 being formed using a deep trench etch process that comprises a plurality of consecutive cycles that are serially performed in situ in an etch reactor. Each cycle comprises an etch step and a deposition step wherein, during the etch step, a source of the bias power is pulsed, while the plasma source power is continuously applied. Alternation of the etch and deposition steps is accomplished by replacing the gaseous mixture in the reaction chamber of the etch reactor and may be performed without termination of a plasma.

FIG. 1C depicts the trench 110 after a deposition step of an intermediate cycle of the deep trench etch process. During the deposition step, a passivation gas is excited to a plasma using a source power and little or no bias power applied to the substrate. As such, the passivation gas forms a sacrificial film 118. Specifically, the film 118 is thin polymeric passivation layer that is deposited on the etch mask 104, sidewalls 114, and the bottom 116 of the trench 110 being etched. The deposition step uses a passivation gas such as at least one of a fluorocarbon or hydrofluorocarbon gas, e.g., at least one of C₄F₈, CHF₃, and the like to form the film 118. The passivation film 118 along the sidewalls of the trench 110 has a thickness that, when the film is applied rapidly, decreases towards a bottom 116 of the trench 110. The thickness of the film 118 may be controlled (e.g., by adjusting a duration of the deposition step) to leave the bottom 116 of the trench 110 uncoated by the film 118, and subsequently exposed to an etchant plasma (discussed in reference to FIG. 1 D below). In a second embodiment, the bottom 116 may be thinly coated (as shown in FIG. 1 C), such that the etchant quickly removes the film at the bottom of the trench before further etching the trench deeper.

FIG. 1D depicts the trench 100 after an etch step of an intermediate cycle of the deep trench etch process. The etch step uses a high density plasma that comprises an etchant, such as sulfur hexafluoride (SF₆) and the like, to increase the etch rate and productivity. In the present invention, during the etch step, a source of the bias power is pulsed while the plasma source power is continuously applied, as discussed above. In one embodiment, the wafer bias power is applied during the etch step for a duration between 1 and 30 msec at a duty cycle of between 10 and 90%. The SF₆ etchant has a selectivity to silicon (layer 112) over photoresist (mask 104) or the polymeric passivation film 118 of about 100:1, and as such, facilitates etching of the deep trenches. Since the etchant consumes the etch mask 104 as the etch process proceeds, the sacrificial passivation film 118 is repeatedly deposited upon the mask after each etch step, in essence, to partially restore the etch mask 104. Note that in FIG. 1 D, after the etch step, the passivation film 118 is illustratively shown as resting only on the sidewalls 114. The film 118 protects the sidewalls 114 as well as improves anisotropy of the deep trench etch process, thus allowing fabrication of the trenches having a high aspect ratio, e.g., about 5 to 50.

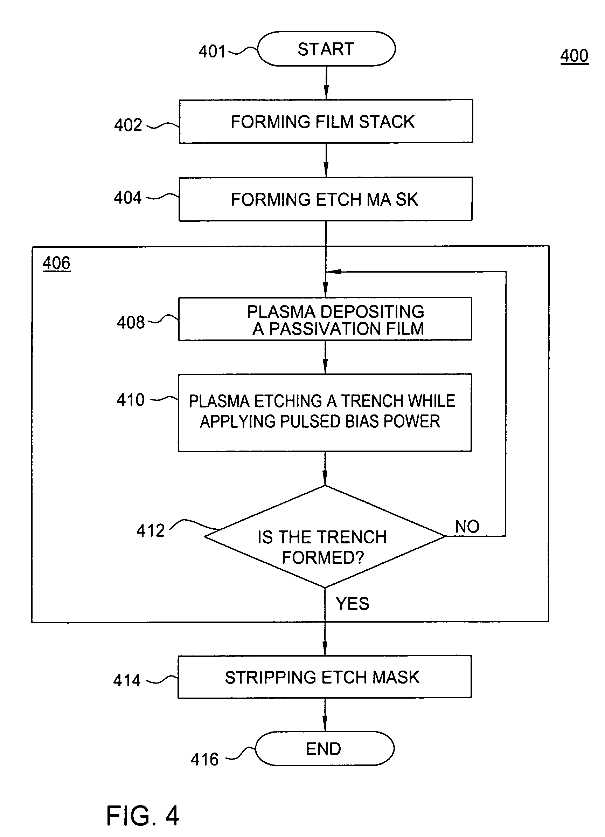

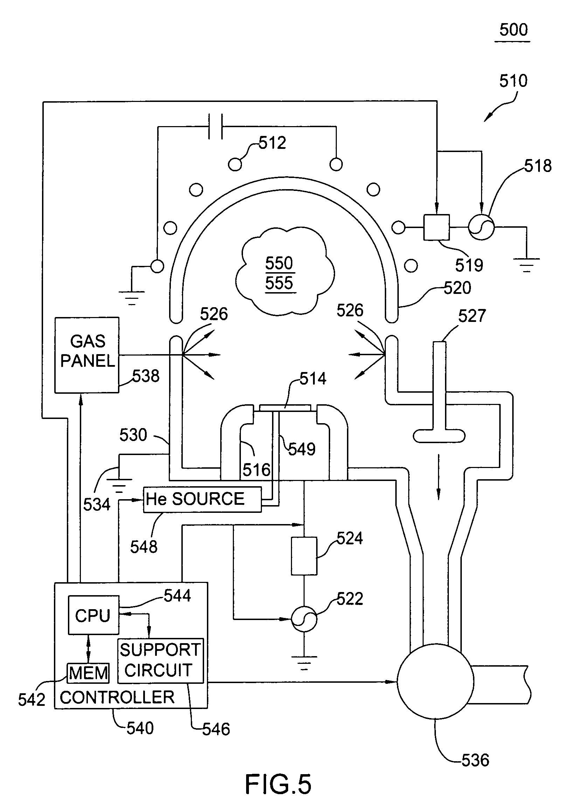

The inventive method can be performed, for example, in a Decoupled Plasma Source - Deep Trench (DPS-DT) reactor, which is a component of the CENTURA ® semiconductor wafer processing systems available from Applied Materials, Inc. of Santa Clara, California. The DPS-DT reactor is discussed in detail with respect to FIG. 5 below. In one embodiment, the DPS-DT reactor uses a 12.56 MHz inductive plasma source (source 518 in FIG. 4 below) to produce a high density plasma, while a wafer is biased by a 400kHz power source (source 522 in FIG. 5 below) of bias power that provides either a pulsed or continuous output. The DPS-DT reactor allows an independent control of ion energy and plasma density, has a wide process window over changes in the plasma source and bias power, pressure, and gas chemistries, and may use an endpoint detection system to determine an end of the etch process.

In an exemplary embodiment, where a DPS-DT reactor is used to etch trenches 110 in silicon, the etch step provides SF₆ at a rate of 20 to 500 sccm, applies 200 to 3000 W of a plasma power and 0 to 300 W of a pulsed biasing power. The pulses have a duration of between 1 and 30 msec at a duty cycle of between 10 and 90%. The reactor maintains a wafer temperature at 10 to 100 degrees Celsius and a pressure in the reaction chamber at 5 to 500 mTorr. One specific process recipe provides SF₆ at a rate of 250 sccm , 1000 W from a plasma power source and 20 W from a pulsed biasing power source for 6 msec at a duty cycle of 33%, a wafer temperature of 10 degrees Celsius, and a chamber pressure of 20 mTorr.

In this illustrative embodiment, the deposition step provides C₄F₈ at a rate of 20 to 500 sccm, applies 200 to 3000 W of a plasma power and 0 to 100 W of a biasing power, and maintains a wafer temperature at 10 to 100 degrees Celsius and a pressure in the reaction chamber at 10 to 100 mTorr. One specific process recipe provides C₄F₈ at a rate of 300 sccm, 1800 W from a plasma power source and no biasing power, a wafer temperature of 10 degrees Celsius, and a chamber pressure of 40 mTorr.

In one embodiment, the method forms a trench, e.g., in silicon, having a width of about 1 to 20 µm and an aspect ratio of about 5 to 50. Further, the roughness of the sidewalls (i.e., scalloping pattern) is reduces to less than 0.1 µm. Those skilled in the art will appreciate that such dimensions should not be considered as limiting.

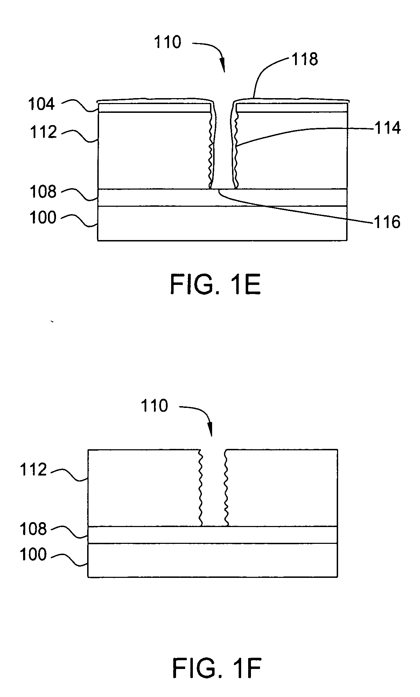

FIG. 1E depicts the wafer 100 after a deep trench 110 has been formed using the method of the present invention. In FIG. 1E, the photoresist etch mask 104 is depicted as partially consumed by the etchant plasma upon the completion of the etch step, as discussed above in reference to FIG. 1 D. The total duration of the deep trench etch process may be controlled upon occurrence of a certain optical emission, e.g., by using an end point detector, upon a particular duration occurring, or some other indicator determining that the trench 110 has been etched to a desired depth.

FIG. 1F depicts the wafer 100 comprising the deep trench 110 after the etch mask 104 has been removed using a conventional photoresist stripping process. The stripping process may be performed, for example, in the Advanced Strip and Passivation (ASP) reactor of the CENTURA® system. The ASP reactor is a microwave downstream oxygen plasma reactor in which the plasma is confined to a plasma tube and only reactive neutrals are allowed to enter a process chamber. Such a plasma confinement scheme precludes plasma-related damage of the substrate or circuits formed on the substrate. The ASP reactor provides temperature control of the wafer. The wafer back side may be heated (e.g., radiantly, by quartz halogen lamps) or cooled (e.g., providing an inert gas such as helium to backside of the wafer) to maintain a wafer temperature between 20 to 400 degrees Celsius. A duration of a stripping process generally is between 30 and 120 seconds.

Alternatively, the photoresist etch mask 104 may be stripped in the DPS-DT reactor. In one embodiment, the stripping process provides to the DPS-DT reactor oxygen (O₂) at a rate of 10 to 300 sccm as well as nitrogen (N₂) at a rate of 0 to 300 sccm (a flow ratio of O₂: N₂ ranging from all oxygen to 1:30), applies 200 to 3000 W of a plasma power and 0 to 100 W of a biasing power, and maintains a wafer temperature at 10 to 100 degrees Celsius and a pressure in the reaction chamber at 5 to 500 mTorr. One specific process recipe provides O₂ at a rate of 100 sccm and N₂ at a rate of 0 sccm, 1000 W from a plasma power source and 0 W from a biasing power source, a wafer temperature of 10 degrees Celsius, and a chamber pressure of 30 mTorr.

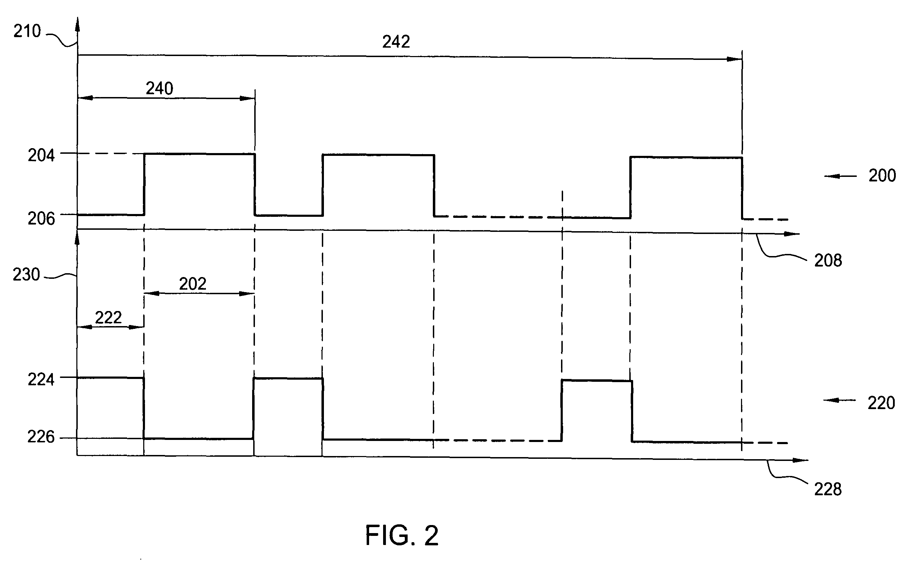

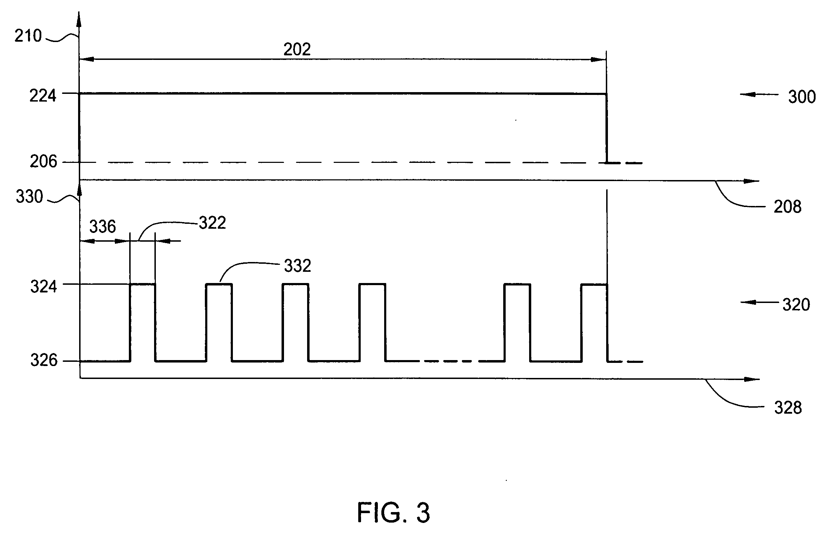

FIGS. 2 and 3 are exemplary timing diagrams of a deep trench etch process that may be used to etch the deep trench 110 in the semiconductor wafer 100, as described above in reference to FIG. 1C.

FIG. 2 depicts a sequence of cycles 240 wherein each cycle 240 comprises a period 202 within which an etch process is performed and a period 222 within which a deposition process is performed. Together, a plurality of cycles 240 comprises a deep trench etch process 242. A first graph 200 depicts a status (y-axis 210) of the etch process, where the etch process is in ON (204) and OFF (206) states versus time (x-axis 208). Correspondingly, a second graph 220 (below) depicts a status (y-axis 230) of the deposition process, where the deposition process is in ON (224) and OFF (226) states versus time (x-axis 228). Specifically, during the time interval 202 of the cycle 240 where the etch process is active (204), the deposition process is inactive (226). Similarly, during the time interval 222 of the cycle 240 where the etch process is inactive (206), the deposition process is active (224). One skilled in the art will understand that the time required to switch between the etching and deposition processes in each cycle 240 is not shown.

In one embodiment where the trench 110 is etched in a silicon wafer, the etch period 202 has a duration between 1 and 40 seconds, while the deposition period 222 has a duration between 1 and 20 seconds. In FIG. 2, the etch process duration 242 begins with the deposition period 222 and ends with the etch period 202. Alternatively, the process 242 may begin with the etch period 202 and end with the deposition period 222 and/or comprise one or more additional etch periods 202 at any time during execution of the etch duration 242. The etch duration 242 generally comprises between 10 and 100 cycles 240 and has a duration between 1 and 40 seconds to etch a trench in silicon having a depth in a range between 1 and 20µm. One skilled in the art will appreciate that the duration of the individual periods 202 and 222 may vary during the etch process due to various factors such as layer composition, layer thickness, and trench dimensions, and the like.

FIG. 3 depicts in detail one individual etch period 202 having an ON state. In accordance with the present invention, period 202 comprises a sequence of time intervals 322 when a bias power is ON, and time intervals 336 when the bias power is OFF. Specifically, in FIG. 3, a first graph 300 depicts a status (y-axis 210) of an individual etch period 202, while a second graph 320 (below) depicts a status (y-axis 330) of the bias power. Similar to the graph 200 in FIG. 2, the graph 300 depicts the ON (204) and OFF (206) states of the etch process versus time (x-axis 208). Correspondingly, the second graph 320 depicts the ON (324) and OFF (326) states of the bias power versus time (x-axis 328). During the etch period 202, the bias power is applied during the time intervals 322 and is terminated during the time interval 336. As such, each active time interval 202 of the etch process is associated with a plurality of bias power pulses, represented the time intervals 322 and 336.

In one exemplary embodiment, a deep trench having a width of about 1 to 20 µm and an aspect ratio of about 5 to 50 may be formed in a silicon wafer by providing the etch step 202 for about 10 seconds and the deposition step 222 for about 5 seconds. The etch step applies a pulse 332 of the bias power during the time intervals 322 having a duration of about 6 msec and terminates the bias power during the time intervals 336 having a duration of about 12 msec (i.e., maintaining a 33% duty cycle).

Figure 4 is a flow diagram of a method 400 for plasma etching a deep trench in accordance with the present invention. The method 400 may be used to form the trenches upon a semiconductor substrate, such as those used to fabricate Micro Electro-Mechanic Systems (MEMS).

The method 400 begins at step 401 and proceeds to step 402. At step 402, a film stack is formed upon a substrate such as the silicon wafer 100, as described above with regard to FIG. 1A. The film stack comprises an etch stop layer (e.g., silicon nitride layer 108) and, for example, the silicon layer 112. At step 404, a photoresist etch mask (e.g., the etch mask 104) is formed on the silicon layer 112 to define the trench 110 to be etched, as described above with regard to FIG. 1 B.

Further, at step 406, the deep trench etch process is performed. Such etch process comprises a period 408 of depositing a protective polymeric film upon the etch mask and sidewalls of trench being etched, a period 410 of etching the trench in the silicon layer, and a decision step 412.

During the period 408, step 406 uses a plasma comprising a polymer-producing fluorocarbon or hydrofluorocarbon gas (e.g., C₄F₈), as described above with regard to FIG. 1 C. The period 408 continues during the time interval 222, as shown in FIG. 2.

During the period 410, step 408 uses a plasma comprising sulfur hexafluoride, as described above with regard to FIG. 1 D. The period 410 continues during the time interval 202, as shown in FIG. 2. In the present invention, during period 410, a source of the bias power for biasing a wafer support pedestal 516 (discussed in reference to FIG. 5 below) is pulsed.

In one embodiment, the bias power is applied during the period 410 for a duration between 1 and 30 msec at a duty cycle of between 10 and 90%. At step 412, the method 400 queries whether the trench has been formed (e.g., etched to a predetermined depth, such as defined by the etch stop layer). In a computerized reactor (for example, in the DPS-DT reactor), at step 412, the decision making routine may be automated using an end-point detection technique. For example, when the etch stop layer is formed from silicon nitride, the endpoint detection system of the referred to DPS-DT reactor may monitor plasma emissions, e.g., at a wavelength of about 288 nm, to determine if the trench has been formed, as described above with regard to FIG. 1 E.

If the query of step 412 is negatively answered, the method 400 repeats step 406 until the trench 110 is formed. As such, the deep trench etch process comprises a plurality of consecutive cycles of depositing a protective polymeric film 118 and etching the silicon layer 112. If the query of step 412 is affirmatively answered, the method 400 proceeds to step 414. At step 414, the etch mask is stripped from the silicon layer 112 using, e.g., a plasma stripping process, as described above with regard to FIG. 1 F. At step 416, the method 400 ends.

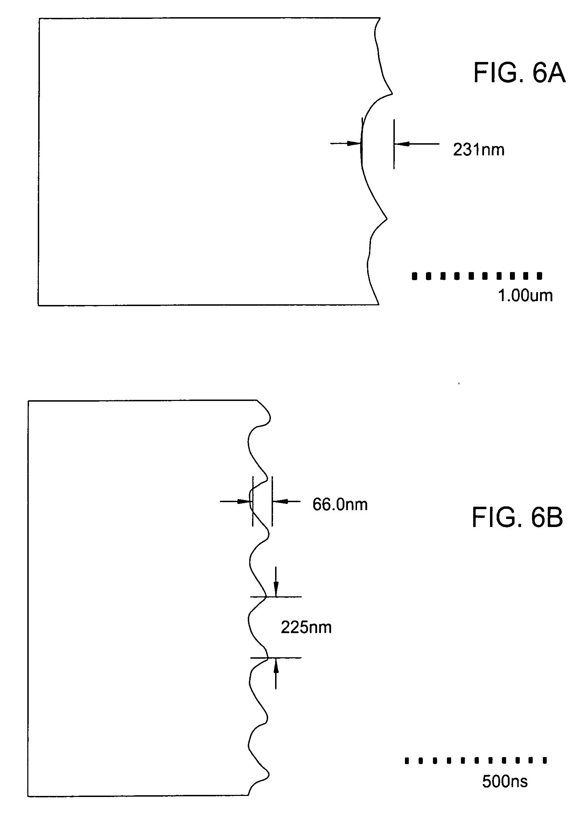

FIGs. 6A and 6B are representations of images from a scanning electron microscope (SEM) that show the sidewall of a trench formed with the foregoing process comprising substantially less scalloping at the sidewalls than results from using a prior art process. For example, in one embodiment, the resulting trench sidewall (FIG. 6A) has peak-to-valley scallops of less than 100 nm as compared to about 200 nm scallops (FIG. 6B) that result from prior art etch processes. In one specific embodiment of the invention, the scalloping was reduced by the inventive process to about 65 nm.

FIG. 5 depicts a schematic diagram of the DPS-DT reactor 500 that may be used to accomplish the method of the present invention. The reactor 500 comprises a process chamber 510 having a wafer support pedestal 516 within a conductive body (wall) 530, and a controller 540.

The support pedestal (cathode) 516 is coupled, through a first matching network 524, to a biasing power source 522. The source 522 generally is capable of producing up to 500 W of continuous and pulsed power at a tunable frequency in a range from 50 kHz to 13.56 MHz. In other embodiments, the source 522 may be a DC or pulsed DC source. The wall 530 is supplied with a dome-shaped dielectric ceiling 520. Other modifications of the chamber 510 may have other types of ceilings, e.g., a flat ceiling. Typically, the wall 530 is coupled to an electrical ground 534. Above the ceiling 520 is disposed an inductive coil antenna 512. The antenna 512 is coupled, through a second matching network 519, to a plasma power source 518. The source 518 typically is capable of producing up to 3000 W at a tunable frequency in a range from 50 kHz to 13.56 MHz.

A controller 540 comprises a central processing unit (CPU) 544, a memory 542, and support circuits 546 for the CPU 544 and facilitates control of the components of the DPS etch process chamber 510 and, as such, of the etch process, as discussed below in further detail.

In operation, a semiconductor wafer 514 is placed on the pedestal 516 and process gases are supplied from a gas panel 538 through entry ports 526 and form a gaseous mixture 550. The gaseous mixture 550 is ignited into a plasma 555 in the chamber 510 by applying power from the sources 518 and 522 to the antenna 512 and the cathode 516, respectively. The pressure within the interior of the chamber 510 is controlled using a throttle valve 527 and a vacuum pump 536. The temperature of the chamber wall 530 is controlled using liquid-containing conduits (not shown) that run through the wall 530.

The temperature of the wafer 514 is controlled by stabilizing a temperature of the support pedestal 516. In one embodiment, the helium gas from a source 548 is provided via a gas conduit 549 to channels formed by the back of the wafer 514 and grooves (not shown) on the pedestal surface. The helium gas is used to facilitate heat transfer between the pedestal 516 and the wafer 514. During the processing, the pedestal 516 may be heated by a resistive heater (not shown) within the pedestal to a steady state temperature and then the helium gas facilitates uniform heating of the wafer 514. Using thermal control, the wafer 514 is maintained at a temperature of between 10 and 500 degrees Celsius.

Those skilled in the art will understand that other forms of etch chambers may be used to practice the invention, including chambers with remote plasma sources, microwave plasma chambers, electron cyclotron resonance (ECR) plasma chambers, and the like.

To facilitate control of the chamber as described above, the controller 540 may be one of any form of general purpose computer processor that can be used in an industrial setting for controlling various chambers and sub-processors. The memory 542 is coupled to the CPU 544. The memory 542, or computer-readable medium, may be one or more of readily available memory such as random access memory (RAM), read only memory (ROM), floppy disk, hard disk, or any other form of digital storage, local or remote. The support circuits 546 are coupled to the CPU 544 for supporting the processor in a conventional manner. These circuits include cache, power supplies, clock circuits, input/output circuitry and subsystems, and the like. Software routines that, when executed by the CPU 544, cause the reactor to perform processes of the present invention are generally stored in the memory 542. The software routines may also be stored and/or executed by a second CPU (not shown) that is remotely located from the hardware being controlled by the CPU 544.

The software routines are executed after the wafer 514 is positioned on the pedestal 516. The software routines, when executed by the CPU 544, transform the general purpose computer into a specific purpose computer (controller) 540 that controls the chamber operation such that the etching process is performed in accordance with the method of the present invention.

Although the present invention is discussed as being implemented as a software routine, some of the method steps that are disclosed herein may be performed in hardware as well as by the software controller. As such, the invention may be implemented in software as executed upon a computer system, in hardware as an application specific integrated circuit (ASIC), or other type of hardware implementation, or a combination of software and hardware.

Although the forgoing discussion referred to fabrication of a deep trench used in MEMS, fabrication of other structures and features used in the MEMS or integrated electronic circuits can benefit from the invention. The invention can be practiced in other etch semiconductor processing systems wherein the processing parameters may be adjusted to achieve acceptable characteristics by those skilled in the art by utilizing the teachings disclosed herein without departing from the spirit of the invention.

## Claims

1. A method for plasma etching a trench in a semiconductor substrate to reduce scalloping of the trench, comprising:
applying a plurality of processing cycles to the substrate, where each cycle comprises a plasma etch period and a plasma deposition period; and
pulsing a substrate bias power during the plasma etch period.

2. The method of claim 1 wherein the trench has a width between 1 to 20 µm and an aspect ratio of about 5 to 50.

3. The method according to any one of the preceding claims wherein the trench has scallops having a peak-to-valley size that is less than 100 nm.

4. The method according to any one of the preceding claims wherein the plasma etch period has a duration between 1 and 40 seconds.

5. The method according to any one of the preceding claims wherein the plasma etch period comprises a plasma etch process that uses an etchant gas comprising SF₆.

6. The method according to any one of the preceding claims wherein the plasma deposition period has a duration between 1 and 20 seconds.

7. The method according to any one of the preceding claims wherein the plasma deposition period comprises a plasma process that uses at least one of a fluorocarbon gas and a hydrofluorocarbon gas.

8. The method of claim 7 wherein the fluorocarbon gas comprises C₄F₈.

9. The method according to claim 7 or 8 wherein the hydrofluorocarbon gas comprises CHF₃.

10. The method according to any one of the preceding claims wherein the pulsing step further comprises:
applying the substrate bias power between 1 and 30 milliseconds at a duty cycle of between 10 and 90%.

11. The method according to any one of the preceding claims wherein the pulsing step further comprises:
applying the substrate bias power for about 6 milliseconds at a duty cycle of about 33%.

12. The method according to any one of the preceding claims wherein a source power is continuously applied to the plasma while the substrate bias power is pulsed.

13. The method of claim 12 wherein the source power has a frequency of about 12.56 MHz and the substrate bias power has a frequency of about 400 KHz.

14. A computer-readable medium including software that, when executed by a processor, performs a method that causes an etch reactor to etch a trench in a semiconductor substrate to reduce scalloping of the trench, comprising:
applying a plurality of processing cycles to the substrate, where each cycle comprises a plasma etch period and a plasma deposition period; and
pulsing a substrate bias power during the plasma etch period.

15. The computer-readable medium of claim 14 wherein the trench has a width between 1 to 20 µm and an aspect ratio of about 5 to 50.

16. The computer-readable medium according to claim 14 or 15 wherein the trench has scallops having a peak-to-valley size that is less than 100 nm.

17. The computer-readable medium according to any one of the claims 14 to 16 wherein the plasma etch period has a duration between 1 and 40 seconds.

18. The computer-readable medium according to any one of the claims 14 to 17 wherein the plasma etch period comprises a plasma etch process that uses an etchant gas comprising SF₆.

19. The computer-readable medium according to any one of the claims 14 to 18 wherein the plasma deposition period has a duration between 1 and 20 seconds.

20. The computer-readable medium according to any one of the claims 14 to 19 wherein the plasma deposition period comprises a plasma process that uses at least one of a fluorocarbon gas and a hydrofluorocarbon gas.

21. The computer-readable medium of claim 20 wherein the fluorocarbon gas comprises C₄F₈.

22. The computer-readable medium according to claim 20 or 21 wherein the hdyrofluorocarbon gas comprises CHF₃.

23. The computer-readbale medium according to any one of the claims 14 to 22 wherein the pulsing step further comprises:
applying the substrate bias power between 1 and 30 milliseconds at a duty cycle of between 10 and 90%.

24. The computer-readable medium according to any one of the claims 14 to 23 wherein the pulsing step further comprises:
applying the substrate bias power for about 6 milliseconds at a duty cycle of about 33%.

25. The method according to any one of the preceding claims wherein a source power is continuously applied to the plasma while the substrate bias power is pulsed.

26. The method of claim 25 wherein the source power has a frequency of about 12.56 MHz and the substrate bias power has a frequency of about 400 KHz.
